# FASCICULE DE BREVET EUROPEEN

(11) **EP 3 351 476 B1**
(45) Date de publication et mention de la délivrance du brevet: **26.08.2020**
(21) Numéro de dépôt: 18152951.2
(22) Date de dépôt: 23.01.2018
(51) Int. Cl.: B64D 41/00, H02B 1/34

(54) **BOÎTIER DE DISTRIBUTION DE PUISSANCE ÉLECTRIQUE POUR UN AÉRONEF**
VERTEILERKASTEN FÜR EIN LUFTFAHRZEUG
CASING FOR DISTRIBUTING ELECTRICAL POWER FOR AN AIRCRAFT

(30) Priorité: 24.01.2017 FR 1700062; 13.06.2017 FR 1755298
(43) Date de publication de la demande: 25.07.2018
(73) Titulaire: Zodiac Aero Electric, 93100 Montreuil (FR)
(72) Inventeur: DESHAYES, Olivier, 93100 Montreuil (FR); PINARD, Frédéric, 93100 Montreuil (FR); BADAULT, Arnaud, 93100 Montreuil (FR); GIRON, Julien, 93100 Montreuil (FR)
(74) Mandataire: Casalonga

(56) Documents cités:
- WO-A1-2015/124722
- US-A- 3 576 515
- US-A- 4 279 459
- US-A1- 2009 273 234

## Description

L'invention concerne un boîtier de distribution de puissance électrique pour un aéronef et un ensemble de distribution de puissance électrique comprenant un tel boîtier de distribution de puissance.

La distribution primaire fait partie du système électrique d'un aéronef, tel qu'un avion. Elle permet de distribuer et protéger la puissance électrique des sources internes, comme les générateurs et les batteries, ou externes, comme le groupe de parc, vers les charges utiles de l'aéronef.

L'ensemble de distribution primaire se compose d'une partie puissance et électronique.

Aujourd'hui, la partie puissance comprenant une ou plusieurs platines de puissance, aussi appelées platines de puissance, est intégrée en fond du châssis au niveau du boîtier de distribution. Les cartes électroniques sont généralement montées à la perpendiculaire de la platine de puissance.

US4279459 et US3576515 décrivent des ensembles permettant de raccorder électriquement et de façon sécurisée une carte électronique rackable entre deux glissières.

Il existe un besoin de diminuer le poids et l'encombrement de l'ensemble formé par le boîtier de distribution comportant le châssis, par les cartes électroniques et par les platines de puissances.

Selon un premier aspect, l'invention a pour objet un boîtier de distribution de puissance électrique pour un aéronef comprenant un châssis contenant au moins un connecteur de puissance formé d'une ou de plusieurs glissières aptes à coopérer avec une extrémité d'une platine de puissance, ladite platine de puissance comprenant au moins un élément de commutation pour plaque de distribution d'énergie électrique, tel que défini plus en détail dans la revendication 1.

Selon des modes particuliers de l'invention, le boîtier de l'invention peut comprendre l'une ou plusieurs des caractéristiques suivantes prises isolément ou selon toutes les combinaisons possibles :
- le châssis contient deux connecteurs de puissance disposées de sorte à recevoir par coulissement les deux extrémités d'une même platine de puissance ce qui permet d'aider à l'insertion et à la mise en place de la platine de puissance ;
- un connecteur de puissance comporte au moins un moyen de compression élastique de puissance configuré pour contraindre l'extrémité de la platine de puissance reçue dans ledit connecteur ce qui permet d'assurer le contact électrique ;
- le moyen de compression élastique de puissance est une lamelle de puissance configurée pour permettre le maintien de la platine de puissance et la dissipation thermique ;
- le ou les connecteurs de puissance sont fixés au châssis par un moyen de fixation, notamment vis et/ou écrou ;
- le ou les connecteurs sont configurés pour recevoir un ou des câbles provenant de l'aéronef.

Selon un autre aspect, l'invention a également pour objet un ensemble de distribution de puissance électrique comprenant un boîtier de l'invention et au moins une platine de puissance comprenant au moins un élément de commutation pour plaque de distribution d'énergie électrique, ladite platine ayant une extrémité apte à coopérer avec un connecteur du boîtier par coulissement.

De préférence, la platine de puissance comporte une plaque froide reliée au châssis du boîtier de distribution.

De préférence, le boîtier de puissance comporte une pluralité de connecteurs reliés entre eux par des barres de puissances.

De préférence, l'ensemble de l'invention comprend en outre au moins une carte électronique, la dite au moins une carte électronique et ladite au moins une platine de puissance ayant une hauteur sensiblement identique et sont disposées parallèlement les unes des autres ce qui permet d'accroitre la compacité de l'ensemble de distribution.

L'invention permet ainsi :
- d'optimiser l'intégration de l'ensemble de distribution de puissance grâce à des platines de puissance glissables ou rackables dans le boîtier de distribution,
- rendre modulaire la partie de puissance du boîtier de distribution,
- libérer la partie intermédiaire du châssis du boîtier de l'invention pour mettre des interfaces de connexion, notamment des interfaces signaux bas niveau dédiées et donc de séparer les connexions de puissance et celle de bas niveau.

D'autres buts, caractéristiques et avantages de l'invention apparaîtront à la lecture de la description suivante, donnée uniquement à titre d'exemple non limitatif et faite en référence aux dessins annexés sur lesquels :

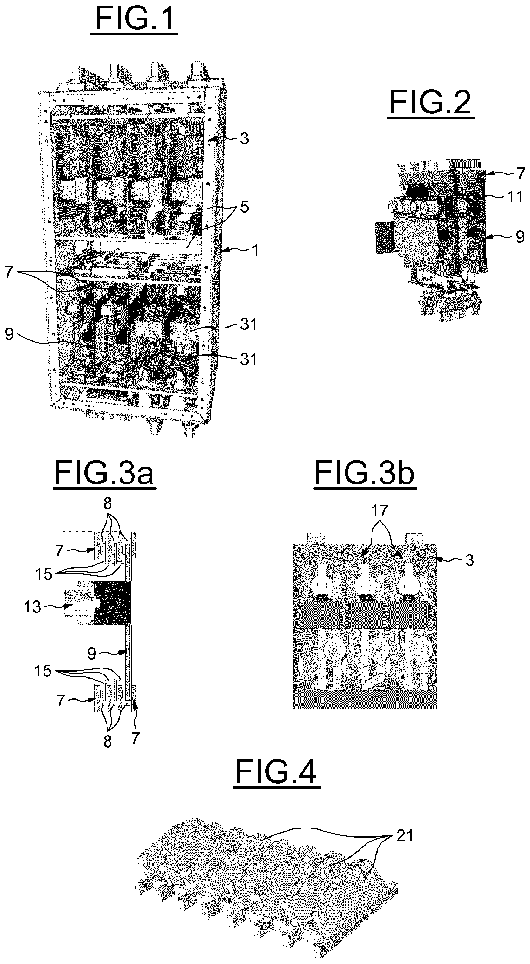

- la figure 1 est une vue en perspective de face d'un mode de réalisation d'un ensemble de distribution de l'invention,
- la figure 2 est une vue en perspective d côté de deux platines de puissance de l'ensemble de distribution de la figure 1,
- La figure 3a est une vue de côté d'une platine de puissance triphasée selon le mode de réalisation de la figure 2,
- La figure 3b est une vue de derrière de la platine du mode de réalisation de la figure 3a,
- La figure 4 est une vue en perspective de côté d'un mode de réalisation de lamelles de puissance,

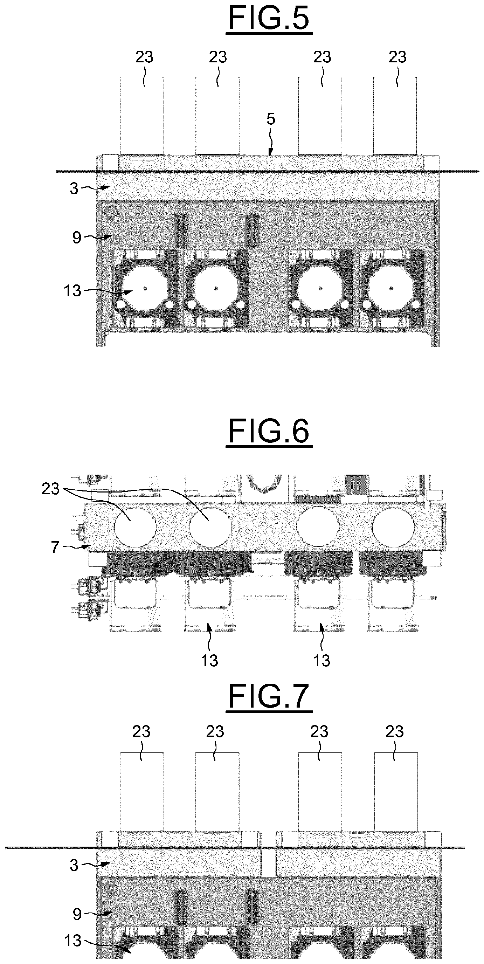

- La figure 5 est une vue schématique partielle de face d'une platine de puissance câblée et avec un connecteur selon le mode de réalisation de la figure 2,
- La figure 6 est une vue schématique partielle de côté de la latine de la figure 5,
- La figure 7 est une vue schématique partielle de face d'une variante de platine de la figure 5 avec deux connecteurs,
- La figures 8 et 9 sont deux vues schématiques partielles d'un ensemble de l'invention avec deux placements différents des platines de puissance,
- La figure 10 est une vue schématique en perspective des barres de distribution d'un semble selon l'invention,
- La figure 11 est une coupe schématique partielle d'un châssis de boîtier de l'ensemble selon l'invention.

Comme illustré sur les figures, l'ensemble de distribution 1 de puissance électrique de l'invention comprend :
- un boîtier 3 de distribution de puissance électrique pour un aéronef comprenant un châssis 5 contenant au moins un connecteur de puissance 7 formé d'une ou de plusieurs glissières 8 aptes à coopérer avec une extrémité 11 d'une platine de puissance 9,
- ladite platine de puissance 9 comprenant au moins un élément de commutation 13 pour plaque de distribution d'énergie électrique.

Le connecteur 7 est configuré de sorte que la ou les glissières 8 reçoivent une ou plusieurs barres 15 de la platine de distribution au niveau de l'extrémité 9 de ladite platine en fonction du nombre de phase.

Ainsi, pour un contacteur AC triphasé, le nombre de barre de distribution de la platine 9 est au nombre de trois et le connecteur comporte trois glissières 8.

Le ou les connecteurs de puissance 7 peuvent être fixés au châssis 3 par un moyen de fixation, notamment vis, écrou. Une telle fixation permet une connexion directe du câblage provenant de l'aéronef, dit « Harnais avion », sur le platine de puissance.

La platine de puissance 9 peut être prise parmi les platines de puissance décrites dans la demande de brevet FR1557879 déposée le 24/08/2015.

De manière avantageuse, la platine de puissance 9 peut comporter une plaque froide 17 reliée au châssis 3 du boîtier de distribution.

Le contact entre la plaque froide 17 et le châssis 3 peut être réalisé par la pression de moyen de compression, comme des lamelles de puissance 21, une ou plusieurs vis ou un système de glissière, tel que le système Calmark™.

La lamelle de puissance 21 peut être configurée pour permettre le maintien de la platine de puissance, la connexion électrique et un transfert thermique de la platine de puissance vers les barres de distribution et/ou la structure de l'aéronef, pour une meilleure dissipation thermique de l'ensemble.

Les contacts par lamelles de puissances 21 peuvent être superposés pour permettre une plus grande surface de contact électrique entre la platine de puissance 9 et les barres de puissance de sortie 41. Si l'on a un contacteur AC Triphasé, la surface de contact peut être égale pour les trois contacts à la surface du contacteur.

Ladite plage de contact et le dimensionnement des lamelles de puissance 21 permettent la conduction thermique entre les barres de distribution 41 et/ou avec la structure de l'aéronef afin d'évacuer le flux de chaleur.

Le ou les connecteurs de puissance 7 peuvent être fixés sur le châssis 3.

Le ou les connecteurs 7 peuvent être configurés pour recevoir un ou des câbles provenant de l'aéronef.

Le ou les câbles avion 23 peuvent être fixés sur le connecteur 7, notamment par sertissage.

De manière avantageuse, l'ensemble 1 selon l'invention peut comprendre en outre au moins une carte électronique 31, la dite au moins une carte électronique 31 et ladite au moins une platine de puissance 9 ayant une hauteur sensiblement identique et sont disposées parallèlement les unes des autres ce qui permet d'accroître la compacité de l'ensemble de l'invention.

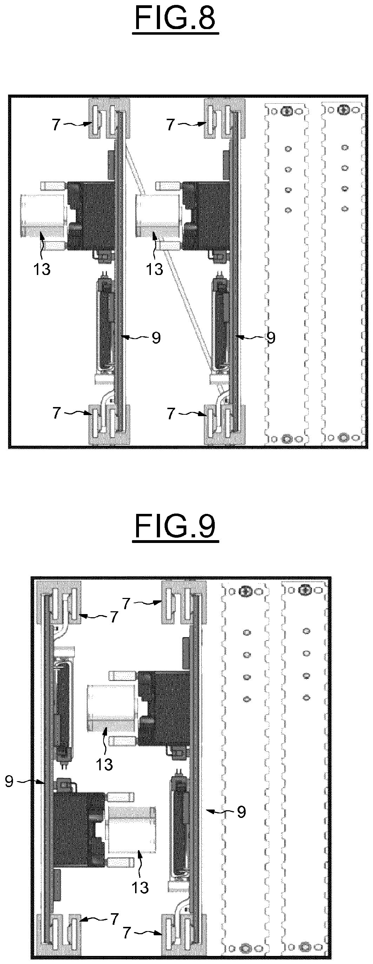

Dans ce cas, les platines de puissance 9 peuvent être disposées de sorte que les éléments de commutation soient disposés dans le même sens (voir figure 8) ou en regard (voir figure 9).

De manière avantageuse, le boîtier de puissance de l'invention peut comporter une pluralité de connecteurs 7 reliés entre eux par des barres de puissances 41.

Le châssis 3 peut contenir deux connecteurs de puissances 7 disposées de sorte à recevoir par coulissement deux extrémités 11 d'une même platine de puissance 9 ce qui permet d'aider à l'insertion et à la mise en place de la platine de puissance 9.

Un connecteur de puissance 7 peut comporter au moins un moyen de compression élastique de puissance (non représenté) configuré pour contraindre l'extrémité 11 de la platine de puissance 9 reçue dans ledit connecteur 7 ce qui permet d'assurer le contact électrique.

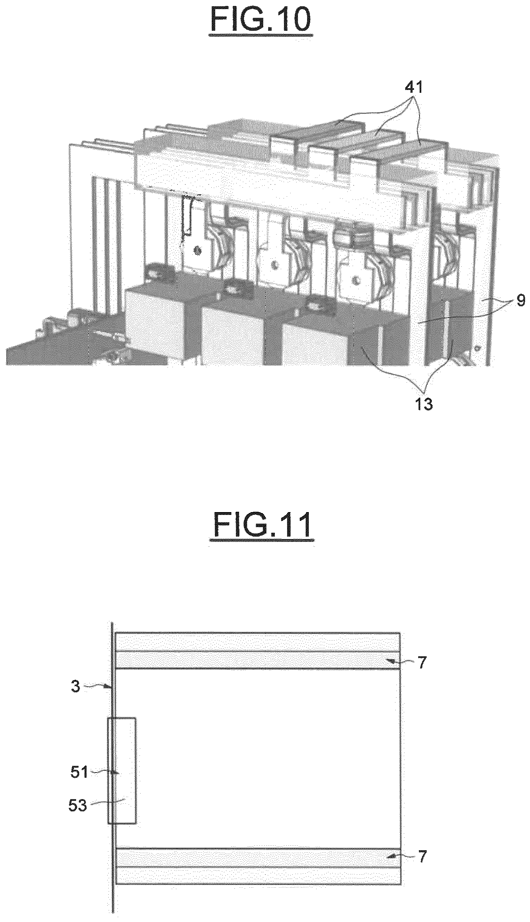

Comme représenté sur la figure 11, l'ensemble de l'invention permet de libérer la partie intermédiaire du châssis 51 du boîtier de l'invention pour mettre des interfaces de connexion 53, notamment des interfaces signaux bas niveau dédiées et donc de séparer les connexions de puissance et celle de bas niveau.

## Revendications

1. Boîtier de distribution de puissance électrique pour un aéronef comprenant un châssis (3) contenant au moins un connecteur de puissance (7) formé d'une ou de plusieurs glissières (8) aptes à coopérer avec une extrémité (11) d'une platine de puissance (9), le connecteur de puissance (7) étant configuré de sorte que la ou les glissières (8) reçoivent une ou plusieurs barres de distribution (15) de la platine de puissance (9) au niveau de l'extrémité (11). ladite platine de puissance (9) comprenant au moins un élément de commutation (13) pour plaque de distribution d'énergie électrique.

2. Boîtier selon la revendication 1 ou 2, dans lequel le châssis (3) contient deux connecteurs de puissance (7) disposées de sorte à recevoir par coulissement les deux extrémités (11) d'une même platine (9) de puissance.

3. Boîtier selon l'une quelconque des revendications précédentes, dans lequel un connecteur de puissance (7) comporte au moins un moyen de compression élastique de puissance (21) configuré pour contraindre l'extrémité (11) de la platine de puissance (9) reçue dans ledit connecteur (7).

4. Boîtier selon la revendication précédente, dans lequel le moyen de compression élastique de puissance est une lamelle de puissance (21) configurée pour permettre le maintien de la platine de puissance (9) et la dissipation thermique depuis la platine de puissance (9) vers des barres de distribution (41) apte à l'évacuation du flux de chaleur et/ou vers la structure de l'aéronef.

5. Boîtier selon l'une quelconque des revendications précédentes, dans lequel le ou les connecteurs de puissance (7) sont fixés au châssis (3) par un moyen de fixation, notamment vis et/ou écrou.

6. Boîtier selon l'une quelconque des revendications précédentes, dans lequel le ou les connecteurs (7) sont configurés pour recevoir un ou des câbles (23) provenant de l'aéronef.

7. Ensemble de distribution de puissance électrique (1) comprenant un boîtier selon l'une quelconque des revendications précédentes et au moins une platine de puissance (9) comprenant au moins un élément de commutation (13) pour plaque de distribution d'énergie électrique, ladite platine ayant une extrémité (11) coopérant avec un connecteur du boîtier (7) par coulissement.

8. Ensemble (1) selon la revendication précédente, dans lequel la platine de puissance (9) comporte une plaque froide (17) reliée au châssis (3) du boîtier de distribution lorsque ladite la platine de puissance (9) est insérée dans l'au moins une glissière (8).

9. Ensemble (1) selon l'une quelconque des revendications 7 ou 8, dans lequel le boîtier de puissance comporte une pluralité de connecteurs (7) reliés entre eux par des barres de puissance (41).

10. Ensemble (1) selon l'une quelconque des revendications 7 à 9, comprenant en outre au moins une carte électronique (31), la dite au moins une carte électronique (31) et ladite au moins une platine de puissance (9) ayant une hauteur sensiblement identique et sont disposées parallèlement les unes des autres.

## Patentansprüche

1. Verteilerkasten elektrischer Leistung für ein Luftfahrzeug, umfassend ein Gestell (3), das mindestens einen Leistungsverbinder (7) enthält, gebildet aus einer oder mehreren Gleitschienen (8), die imstande sind, mit einem Ende (11) einer Leistungsplatine (9) zusammenzuwirken, wobei der Leistungsverbinder (7) derart ausgelegt ist, dass die Gleitschiene (n) (8) eine oder mehrere Verteilerleisten (15) der Leistungsplatine (9) im Bereich des Endes (11) aufnehmen, wobei die Leistungsplatine (9) mindestens ein Umschaltelement (13) für Stromverteilerplatte umfasst.

2. Kasten nach Anspruch 1 oder 2, wobei das Gestell (3) zwei Leistungsverbinder (7) enthält, die derart angeordnet sind, dass sie durch Gleiten die zwei Enden (11) derselben Leistungsplatine (9) aufnehmen.

3. Kasten nach einem der vorangehenden Ansprüche, wobei ein Leistungsverbinder (7) mindestens ein elastisches Leistungskompressionsmittel (21) aufweist, das ausgelegt ist, um das Ende (11) der in dem Verbinder (7) aufgenommenen Leistungsplatine (9) zu belasten.

4. Kasten nach vorangehendem Anspruch, wobei das elastische Leistungskompressionsmittel eine Leistungslamelle (21) ist, die ausgelegt ist, um den Halt der Leistungsplatine (9) und die Wärmeableitung ab der Leistungsplatine (9) zu den Verteilerleisten (41) zu gestatten, die zur Ableitung des Wärmestroms und/oder zu der Struktur des Luftfahrzeugs imstande ist.

5. Kasten nach einem der vorangehenden Ansprüche, wobei der oder die Leistungsverbinder (7) mit einem Befestigungsmittel, insbesondere Schraube und/oder Mutter, am Gestell (3) befestigt sind.

6. Kasten nach einem der vorangehenden Ansprüche, wobei der oder die Verbinder (7) ausgelegt sind, um ein oder Kabel (23) aufzunehmen, die vom Luftfahrzeug kommen.

7. Verteilereinheit elektrischer Leistung (1), umfassend einen Kasten nach einem der vorangehenden Ansprüche und mindestens eine Leistungsplatine (9), umfassend mindestens ein Umschaltelement (13) für Stromverteilerplatte, wobei die Platine ein Ende (11) hat, das mit einem Verbinder des Kastens (7) durch Gleiten zusammenwirkt.

8. Einheit (1) nach vorangehendem Anspruch, wobei die Leistungsplatine (9) eine kalte Platte (17) aufweist, die mit dem Gestell (3) des Verteilerkastens verbunden ist, wenn die Leistungsplatine (9) in die mindestens eine Gleitschiene (8) eingesetzt ist.

9. Einheit (1) nach einem der Ansprüche 7 oder 8, wobei der Leistungskasten eine Vielzahl von Verbindern (7) aufweist, die untereinander durch Leistungsschienen (41) verbunden sind.

10. Einheit (1) nach einem der Ansprüche 7 bis 9, umfassend ferner mindestens eine elektronische Karte (31), wobei die mindestens eine elektronische Karte (31) und die mindestens eine Leistungsplatine (9) eine etwa identische Höhe haben und zueinander parallel angeordnet sind.

## Claims

1. Casing for distributing electrical power for an aircraft comprising a frame (3) containing at least one power connector (7) formed of one or more rails (8) capable of cooperating with an end (11) of a power plate (9), the power connector (7) being configured such that the rails (8) receive one or more distribution bars (15) of the power plate (9) at the end (11), said power plate (9) comprising at least one switching element (13) for an electrical energy distribution plate.

2. Casing according to claim 1 or 2, wherein the frame (3) contains two power connectors (7) arranged so as to slidingly receive the two ends (11) of one same power plate (9).

3. Casing according to any one of the preceding claims, wherein a power connector (7) comprises at least one power elastic compression means (21) configured to force the end (11) of the power plate (9) received in said connector (7).

4. Casing according to the preceding claim, wherein the power elastic compression means is a power strip (21) configured to allow the power plate (9) and the thermal dissipation to be held from the power plate (9) to distribution bars (41) capable of evacuating the heat stream and/or to the structure of the aircraft.

5. Casing according to any one of the preceding claims, wherein the one or more power connectors (7) are fastened to the frame (3) by fastening means, in particular screws and/or nuts.

6. Casing according to any one of the preceding claims, wherein the one or more connectors (7) are configured to receive one or more cables (23) coming from the aircraft.

7. Electrical power distribution assembly (1) comprising a casing according to any one of the preceding claims and at least one power plate (9) comprising at least one switching element (13) for an electrical energy distribution plate, said plate having an end (11) cooperating slidingly with a connector of the casing (7).

8. Assembly (1) according to the preceding claim, wherein the power plate (9) includes a cold plate (17) connected to the frame (3) of the distribution casing when said power plate (9) is inserted in the at least one rail (8).

9. Assembly (1) according to any one of claims 7 or 8, wherein the power casing comprises a plurality of connectors (7) connected together by power bars (41).

10. Assembly (1) according to any one of claims 7 to 9, further comprising at least one electronic board (31), said at least one electronic board (31) and said at least one power plate (9) having a substantially identical height and being arranged parallel to one another.
